# EUROPÄISCHE PATENTSCHRIFT

(11) **EP 4 485 099 B1**
(45) Veröffentlichungstag und Bekanntmachung des Hinweises auf die Patenterteilung: **19.11.2025**
(21) Anmeldenummer: 23182852.6
(22) Anmeldetag: 30.06.2023
(51) Int. Cl.: G05B 19/042

(54) **LEITSYSTEM FÜR EINE TECHNISCHE ANLAGE UND BETRIEBSVERFAHREN**
CONTROL SYSTEM FOR A TECHNICAL INSTALLATION AND OPERATING METHOD
SYSTÈME DE GUIDAGE POUR UNE INSTALLATION TECHNIQUE ET PROCÉDÉ DE FONCTIONNEMENT

(43) Veröffentlichungstag der Anmeldung: 01.01.2025
(73) Patentinhaber: Siemens Aktiengesellschaft, 80333 München (DE)
(72) Erfinder: Lutz, Benjamin, 76327 Pfinztal (DE)
(74) Vertreter: Siemens Patent Attorneys

(56) Entgegenhaltungen:
- US-A1- 2017 046 057
- US-A1- 2019 102 055

## Beschreibung

Die Erfindung betrifft ein Leitsystem für eine Fertigungs- oder Prozessanlage, das wenigstens einen Operator Station Server und wenigstens einen mit dem Operator Station Server verbundenen Operator Station Client umfasst, wobei der Operator Station Server dazu ausgebildet ist, Visualisierungsinformationen an den Operator Station Client zu übertragen, wobei die Visualisierungsinformationen eine Mehrzahl von wechselbaren Anlagenbildern umfassen, und wobei der Operator Station Client dazu ausgebildet ist, die Visualisierungsinformationen mit den wechselbaren Anlagenbildern für einen Operator der Fertigungs- oder Prozessanlage darzubieten. Außerdem betrifft die Erfindung ein Verfahren zum Betreiben eines Leitsystems für eine Fertigungs- oder Prozessanlage.

Für die Bedienung und Beobachtung verfahrenstechnischer Anlagen werden symbolische Anlagenbilder erstellt, die die verfahrenstechnischen Zusammenhänge - insbesondere zwischen den Prozessobjekten - abstrahiert darstellen. Anlagenbilder setzen sich dabei aus statischen Symbolen (z.B. Leitungen, Rechtecke), dynamisierten Symbolen (z.B. in Abhängigkeit von Prozesswerten Leitungen mit Farbumschlag, Rechtecke mit Füllständen), Blocksymbolen (zur dynamisierten Visualisierung verfahrenstechnischer Prozessobjekte), komplexen Controls (z.B. Trendanzeigen, Meldefolgeanzeigen), Containern, um Inhalte aus unabhängigen und eigenständige Quellen visualisieren zu können (z.B. Webcams, Anlagenbilder modularer Anlagenteile (Package Units) oder Apps (z.B. Regleroptimierer, KPI-Berechnungen) zusammen.

Weiterhin können Anlagenbilder auch zahlreiche Textfelder umfassen, um beispielsweise Messstellen zu bezeichnen oder Kommentare einzufügen. Die Farbgebung von Symbolen und ähnlichem stützt sich dabei in der Regel auf symbolische Farben, die an zentraler Stelle des Engineerings der Prozessanlage vorkonfiguriert und in den unterschiedlichen Editoren genutzt werden. Um Ereignisse visuell besser darstellen zu können, können in Abhängigkeit verfahrenstechnischer Zustände Anlagenbildinhalte zum Blinken gebracht werden - mit unterschiedlichen Frequenzen.

Die Eigenschaften der Anlagenbilder werden im Engineering an entsprechenden Arbeitsplätzen konfiguriert, wobei es nicht möglich ist, die entstehenden Anlagenbilder unter allen Randbedingungen zu beurteilen, unter denen sie für die Bedienung und Beobachtung genutzt werden. Dies bedeutet, dass die Prüfung von Anlagenbildern auf Barrierefreiheit im Engineering nicht vollständig erfolgen kann, da die Randbedingungen nicht alle bekannt sind, wie beispielsweise:
- die individuelle Sehkraft des Operators
- die tatsächlich eingesetzten Ausgabegeräte (vom mobilen Endgerät bis zur Großbildleinwand in der Leitwarte)
- die Umgebungsbedingungen (von der gedimmten Warte bis hin zur direkten Sonneneinstrahlung im Feld)

In der EP 3 876 046 A1 ist ein Leitsystem einer technischen Anlage offenbart, welches eine Anpassungen einer durch einen Operator Station Client erfolgten Darbietung von Visualisierungsinformationen durch einen Operator zu einer Laufzeit der technischen Anlage ermöglicht.

Aus der US 2019/0102055 A1 ist ein Prozessleitsystem bekannt, welches Anlagenbilder für einen Operator einer durch das Prozessleitsystem bedient und beobachteten Prozessanlage grafisch bereitstellt.

Der Erfindung liegt die Aufgabe zugrunde, ein Leitsystem für eine Prozess- oder Fertigungsanlage anzugeben, bei welchem die individuelle und umgebungsbedingte Barrierefreiheit der projektierten Anlagenbilder bei Bedarf ad hoc zu Laufzeit geprüft werden können, um sicherzustellen, dass in der gegenwärtigen Situation auch alle relevanten Aspekte der vorhandenen Anlagenbilder für eine sichere Bedienung und Beobachtung wahrgenommen werden können.

Diese Aufgabe wird gelöst durch ein Leitsystem für eine Prozess- oder Fertigungsanlage mit den Merkmalen des Anspruchs 1. Außerdem wird die Aufgabe gelöst durch ein Verfahren zum Betreiben eines Leitsystems für eine Fertigungs- oder Prozessanlage gemäß Anspruch 11. Vorteilhafte Weiterbildungen ergeben sich aus den abhängigen Ansprüchen.

Ein erfindungsgemäßes Leitsystem für eine Fertigungs- oder Prozessanlage umfasst wenigstens einen Operator Station Server und wenigstens einen mit dem Operator Station Server verbundenen Operator Station Client, wobei der Operator Station Server dazu ausgebildet ist, Visualisierungsinformationen an den Operator Station Client zu übertragen, wobei die Visualisierungsinformationen eine Mehrzahl von wechselbaren Anlagenbildern umfassen, und wobei der Operator Station Client dazu ausgebildet ist, die Visualisierungsinformationen mit den wechselbaren Anlagenbildern für einen Operator der Fertigungs- oder Prozessanlage darzubieten.

Das erfindungsgemäße Leitsystem ist dadurch gekennzeichnet, dass das Leitsystem dazu ausgebildet ist, dem Operator der Fertigungs- oder Prozessanlage zur Laufzeit der Fertigungs- oder Prozessanlage ein von den Anlagenbildern verschiedenes Testbild darzubieten, welches einen Farbbereich mit den in wenigstens zwei der Anlagenbilder der Visualisierungsinformationen verwendeten Farben umfasst. Das Leitsystem ist weiterhin dazu ausgebildet, eine dem Testbild zugeordnete Alarmmeldung zu erzeugen, welche durch den Operator quittierbar ist. Dabei ist eine Alarmmeldung eine Meldung, die eine in der Regel unverzügliche Reaktion eines Operators des technischen Systems erfordert. Unter einer Meldung wird dabei ein Bericht vom Eintreten eines Ereignisses verstanden, das einen Übergang aus einem diskreten Zustand innerhalb des technischen Systems in einen anderen diskreten Zustand darstellt. Durch die (nicht quittierte) Alarmmeldung ist es für den betroffenen Operator oder für weitere Operatoren klar ersichtlich, dass die Beurteilung des Testbildes durch den Operator noch aussteht. Eine Alarmmeldung kann zudem in bereits vorhandene Alarmmeldemechanismen des Leitsystems einfach eingebunden werden.

Zudem ist das Leitsystem erfindungsgemäß dazu ausgebildet, dem Operator eine visuelle Darbietung der Anlagenbilder zu verweigern, bis die dem Testbild zugeordnete Alarmmeldung quittiert worden ist. Mit anderen Worten muss der Operator das Testbild aktiv quittieren, bevor er die von dem Testbild berücksichtigten Anlagenbilder für die Bedienung und Beobachtung verwenden kann. Dadurch kann sichergestellt werden, dass eine Prüfung der Anlagenbilder auf "Barrierefreiheit" auch tatsächlich vorgenommen wird.

Bei der technischen Anlage kann es sich um eine Anlage aus der Prozessindustrie wie beispielsweise eine chemische, pharmazeutische, petrochemische oder eine Anlage aus der Nahrungs- und Genussmittelindustrie handeln. Hiermit umfasst sind auch jegliche Anlagen aus der Produktionsindustrie, Werke, in denen z.B. Autos oder Güter aller Art produziert werden.

Unter einem Leitsystem wird im vorliegenden Kontext ein computergestütztes, technisches System verstanden, das Funktionalitäten zum Darstellen, Bedienen und Leiten der verfahrenstechnischen Anlage umfasst. Das Leitsystem kann auch Sensoren zur Ermittlung von Messwerten sowie verschiedene Aktoren umfassen. Zudem kann das Leitsystem sogenannte prozess- oder fertigungsnahe Komponenten umfassen, die zur Ansteuerung der Aktoren bzw. Sensoren dienen. Darüber hinaus kann das Leitsystem u.a. Mittel zur Visualisierung der verfahrenstechnischen Anlage und zu einem Engineering aufweisen. Das Leitsystem kann optional auch weitere Recheneinheiten für komplexere Regelungen und Systeme zur Datenspeicherung und -verarbeitung umfassen.

Unter einem "Operator Station Server" wird vorliegend ein Server verstanden, der zentral Daten eines Bedien- und Beobachtungssystems sowie in der Regel Alarm- und Messwertarchive eines Leitsystems einer technischen Anlage erfasst und Benutzern zur Verfügung stellt. Der Operator Station Server stellt in der Regel eine Kommunikationsverbindung zu Automatisierungssystemen der technischen Anlage her und gibt Daten der technischen Anlage zur Visualisierung an sogenannte Operator Station Clients weiter, die zur Bedienung und Beobachtung eines Betriebs der einzelnen Funktionselemente der technischen Anlage dienen. Der Operator Station Server kann über Client-Funktionen verfügen, um auf die Daten (Archive, Meldungen, Tags, Variablen) anderer Operator Station Server zuzugreifen.

Dadurch sind Bilder eines Betriebs der technischen Anlage auf dem Operator Station Server mit Variablen anderer Operator Station Server (Server-Server-Kommunikation) kombinierbar. Bei dem Operator Station Server kann es sich, ohne sich darauf zu beschränken, um einen SIMATIC PCS 7 Industrial Workstation Server der Firma SIEMENS handeln.

Ein Operator der technischen Anlage kann über den Operator Station Client, welcher beispielsweise ein Tablet, ein Smartphone, ein Personal Computer oder dergleichen sein kann, zum Zwecke eines Bedienens und Beobachtens der technischen Anlage auf den Operator Station Server zugreifen.

Unter einer Visualisierung wird vorliegend die grafische Darbietung verstanden, die für den Operator durch den Operator Station Client erfolgt. In der Regel verfügt der Operator Station Client über entsprechende Funktionalitäten, einschlägige Visualisierungsinformationen, die er vom Operator Station Server erhält, zur Erzeugung der beabsichtigten Visualisierung zu nutzen. Dabei kann die Visualisierung allgemein in an sich bekannter Weise Anlagenbilder, grafische Fenster mit Verlaufsanzeigen von Messwerten, Meldungsanzeigen, grafische Objekte, die technische Objekte der technischen Anlage repräsentieren, und dgl. umfassen. Im Falle einer Prozessanlage kann solch ein Anlagenbild beispielsweise grafische Repräsentationen von Pumpen, Ventilen, Tanks, Rohrleitungen, Brennkammern oder dergleichen umfassen. Die grafischen Repräsentationen können dabei aktuelle Prozessmesswerte, Statuswerte, (Alarm-)Meldungen oder dergleichen umfassen.

Das erfindungsgemäße Leitsystem ist dazu ausgebildet, zur Laufzeit der technischen Anlage, d.h. während eines Betriebes der technischen Anlage, dem Operator ein separates, von den eigentlichen Anlagenbildern verschiedenes Testbild visuell darzubieten. Dieses Testbild umfasst die Farben von wenigstens zwei der Anlagenbilder, die im Engineering der Fertigungs- oder Prozessanlage, d.h. bei der Projektierung der Automatisierung für die Fertigungs- oder Prozessanlage, erzeugt und dem Operator Station Server zur Verfügung gestellt worden sind. Dabei können die Farben in an sich beliebiger Art und Weise dargestellt werden. Beispielsweise können Kreise oder Quadrate mit den in den wenigstens zwei Anlagenbildern verwendeten Farben dargestellt werden.

Mithilfe dieses Testbildes kann der Operator unmittelbar in der Situation, in der er die Anlagenbilder zur Bedienung und Beobachtung der Fertigungs- oder Prozessanlage einsetzen möchte, die für ihn erkennbare Farbgebung prüfen und ggf. Korrekturmaßnahmen einleiten. Im Rahmen dessen kann der Operator beispielsweise prüfen, ob er gelbe und rote Farben korrekt erkennen kann, da diese auf Warnungen bzw. Alarme hinweisen und von dem Operator unmittelbar und eindeutig erkannt werden können müssen. In der Regel werden bei der Projektierung / dem Engineering der Analgenbilder vordefinierte symbolische Farben verwendet, die im Engineering an einer zentralen Stelle definiert werden. Dabei besitzen z.B. das Medium "Wasser", die Alarmklasse "Critical" usw. stets denselben Farbton. Die symbolischen Farben sind somit von zentraler Bedeutung und es muss sichergestellt werden, dass zwischen den verschiedenen Farben auch klar unterschieden werden kann. Damit dies überprüft werden kann, wird die symbolische Farbenpalette in das automatisch erzeugte Anlagenbild "Visualization Validation" platziert.

Das Testbild berücksichtigt die Farben von wenigstens zwei Anlagenbildern. Bevorzugt werden alle Anlagenbilder, die in dem Engineering erzeugt und auf den Operator Station Server übertragen worden sind, für das Testbild berücksichtigt.

Das Testbild kann zusätzlich zu den Farben auch einen Textbereich mit den in den Anlagenbildern verwendeten Schriften und Schriftgrößen umfassen. Anlagenbilder enthalten in der Regel mehrere Textfelder und verschiedenste Texte zur Bezeichnung von Symbolen, Messstellen usw. Die Texte können in unterschiedlichen Schriftarten und Schriftgrößen in den Anlagenbildern projektiert werden. Dabei können alle in den (wenigstens zwei, vorzugsweise allen) Anlagenbildern verwendeten Schriftarten bzw. Schriftgrößen berücksichtigt und in dem Testbild dargestellt werden. Es ist aber auch möglich, dass nur die kleinste in den Anlagenbildern verwendete Schriftgrö-ße dargestellt wird. Der Operator kann hierdurch direkt erkennen, ob er alle Schriften / Schriftarten auch korrekt erkennen kann.

Im Testbild können auch Zwischengrößen berücksichtigt werden, um die "lesbaren" Übergänge besser erkennen zu können. Je nach Ausgabegerät, Lichtverhältnis und Sehstärke kann der Operator damit individuell überprüfen, ob er gegenwärtig in der Lage ist, die kleinsten in einem Anlagenbild vorhandenen Texte entziffern zu können.

Besonders bevorzugt umfasst das Testbild einen Blinkbereich mit den in den Anlagenbildern verwendeten Blinkfrequenzen. In Anlagenbildern können Symbole oder Statusanzeigen über unterschiedlich frequentes Blinken dynamisiert werden. Die Wahrnehmbarkeit der Blinkfrequenz kann dabei je nach Endgerät, Umgebungseinflüssen und ähnlichem variieren. Die in den Anlagenbildern projektierten Blinkfrequenzen können dabei in dem Testbild über Statussymbole zur Prüfung durch den Operator visualisiert werden.

Das Testbild kann auch einen Symbolbereich umfassen, der nach bestimmten Kriterien ausgewählte, in den Anlagenbildern enthaltene Symbolbilder umfasst. Für die abstrahierte grafische Darstellung verfahrenstechnischer Prozesse werden (dynamisierte) Symbole verwendet. Für das Testbild können einige der grafischen Symbole ermittelt und platziert werden, so dass der Operator individuell und umgebungsbedingt prüfen kann, ob er die Symbole und deren Dynamisierung detailliert wahrnehmen kann. Bevorzugt werden die Symbolbilder gemäß ihrer Größe ausgewählt, derart, dass der Symbolbereich eine zu bestimmende Anzahl der kleinsten Symbolbilder umfasst.

Der Operator der Fertigungs- oder Prozessanlage kann vorzugsweise zur Laufzeit der Fertigungs- oder Prozessanlage vorgeben, welche der Anlagenbilder für die Erzeugung des Testbildes berücksichtigt werden sollen. Der Operator kann dabei variabel vorgeben, ob er beispielsweise das Anlagenbild X und das Anlagenbild Y für die Erzeugung des Testbildes berücksichtigt haben will, weil ihn diese beiden Anlagenbilder besonders betreffen.

Im Rahmen einer bevorzugten Weiterbildung der Erfindung ist das Leitsystem dazu ausgebildet, bei einer Anwahl eines Bereiches des Testbildes dem Operator das Anlagenbild visuell darzubieten, welches bei der Erzeugung des Bereiches berücksichtigt worden ist. Wenn der Operator beispielsweise eine Farbe im Farbbereich oder eine Schrift im Textbereich anwählt, bietet ihm der Operator Station Server bzw. der Operator Station Client dasjenige Anlagenbild dar, welches die Farbe oder die Schrift umfasst. Der Operator kann dadurch erkennen, welches Anlagenbild ihm potenziell Schwierigkeiten bereiten könnte. Zudem sieht er die Farbe oder die Schrift im Kontext des betreffenden Anlagenbereichs und kann dadurch besser beurteilen, ob tatsächlich Wahrnehmungsprobleme auftreten können.

Die Alarmmeldung kann als durch den Operator kommentierbar ausgebildet sein. Diese Kommentare können beispielsweise von einem Projekteur der Fertigungs- oder Prozessanlage gelesen werden, welcher eine Anpassung der Anlagenbilder vornehmen kann. Der Operator kann dem Projekteur oder anderen Operatoren dabei beispielsweise mitteilen, dass die Farbe "Rot" im Anlagenbild Z oder der Text im Anlagenbild XY nicht richtig zu erkennen sind, worauf der Projekteur beispielsweise eine Anpassung des Kontrastes oder der Farbsättigung vornehmen kann.

Bevorzugt ist die Erzeugung der Alarmmeldung von einem Aufenthaltsort und/oder einer Identität und/oder einer Rolle des Operators abhängig. Beispielsweise kann das Quittieren der Alarmmeldung besonders dann wichtig sein, wenn sich der Operator in einer besonderen Umgebung aufhält (dunkel, vernebelt, Streulicht etc.).

Die Aufgabe wird zudem gelöst durch ein Verfahren gemäß Anspruch 11.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Es zeigen:
- FIG 1: eine grafische Darbietung eines Testbildes gemäß einem ersten Aspekt;
- FIG 2: eine grafische Darbietung eines Anlagenbildes;
- FIG 3: eine grafische Darbietung eines Testbildes gemäß einem zweiten Aspekt; und
- FIG 4: ein erfindungsgemäßes Leitsystem in einer schematischen Darstellung.

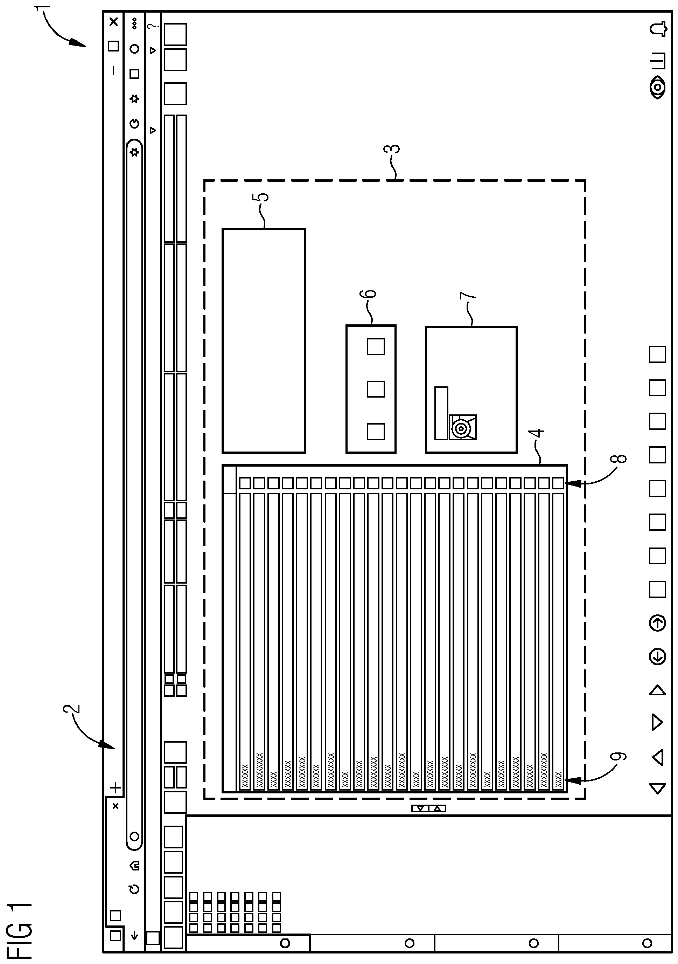

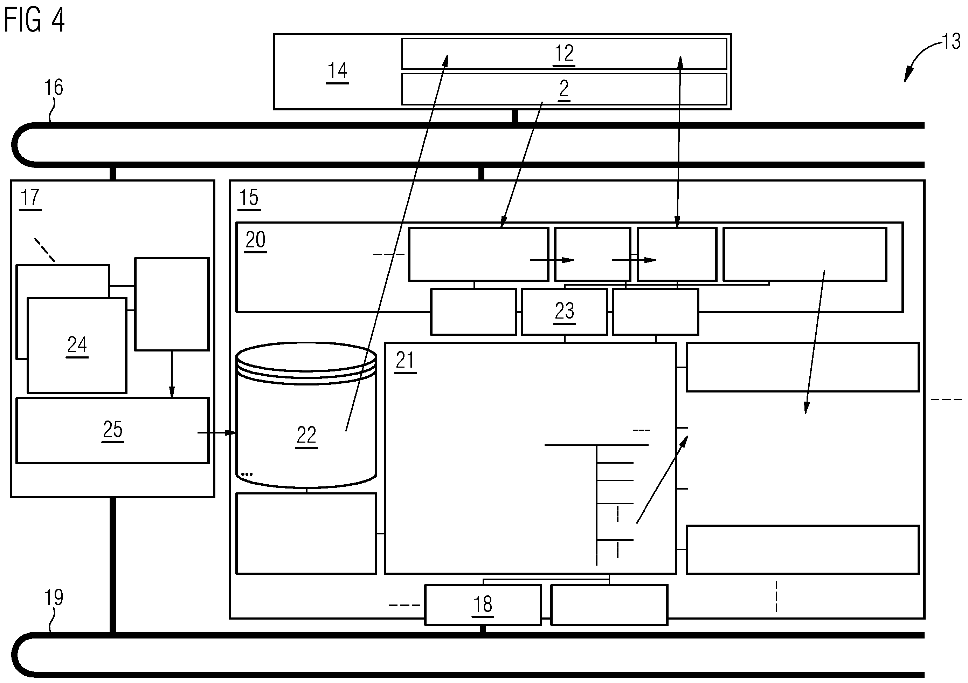

In FIG 1 ist eine Visualisierung 1 dargestellt, welche ein Operator Station Client (vgl. FIG 4) einem Operator einer Prozessanlage zur Bedienung und Beobachtung der Prozessanlage darbietet. Die Visualisierung umfasst neben hier nicht näher beschriebenen Bedienelementen 2 ein Testbild 3, welches in FIG 1 zur besseren Erkennbarkeit mit einem gestrichelten Rahmen gekennzeichnet ist.

Das Testbild 3 weist einen Farbbereich 4, einen Textbereich 5, einen Blinkbereich 6 und einen Symbolbereich 7 auf.

In dem Farbbereich 4 sind in einer Spalte 8 alle Farben dargestellt, die in den verschiedenen Anlagenbildern einer Automatisierung für die Prozessanlage verwendet werden. Die Anlagenbilder dienen dabei der Bedienung und Beobachtung der Prozessanlage. Die Farben sind jeweils in einer quadratischen Form dargestellt. In einer links von der Farbspalte 8 in FIG 1 dargestellten Namensspalte 9 ist jeweils eine Bezeichnung wie "Closed", "Active" oder "Stopped" dargestellt, welche im Zusammenhang mit der Verwendung der jeweiligen Farbe in den Anlagenbildern steht.

In dem Textbereich 5 ist eine Auswahl der Schriften dargestellt, die in den Anlagenbildern eingesetzt werden. Dabei können in dem Textbereich 5 beispielsweise die fünf Schriften mit den geringsten Schriftgrößen und die fünf Schriften mit den größten Schriftgrößen dargestellt sein.

In dem Blinkbereich 6 sind die in den Anlagenbildern verwendeten Blinkanimationen in Form von blinkenden Quadraten dargestellt. Die Quadrate sind dabei nach verwendeter Blinkfrequenz getrennt dargestellt.

In dem Symbolbereich 7 sind beispielsweise die fünf kleinsten Symbole dargestellt, die in den Anlagenbildern verwendet werden. In FIG 1 ist nur ein Symbol beispielhaft dargestellt.

Bei einer Anwahl eines der Bereiche 4, 5, 6, 7 des Testbildes 3 durch den Operator wird dem Operator das Anlagenbild visuell dargeboten, welches bei der Erzeugung des Bereiches 4, 5, 6, 7 berücksichtigt worden ist. Wenn der Operator beispielsweise auf den Schriftzug "Extraction" mit der Maus klickt oder mit der Hand tippt, wird im von dem Leitsystem bzw. dem dazugehörigen Operator Station Client (vgl. FIG 4) dasjenige Anlagenbilder dargestellt, in welchem der Schriftzug "Extraction" verwendet wird. Damit kann der Operator den Schriftzug auf einfache und schnelle Art und Weise den Kontext des Schriftzuges erfahren.

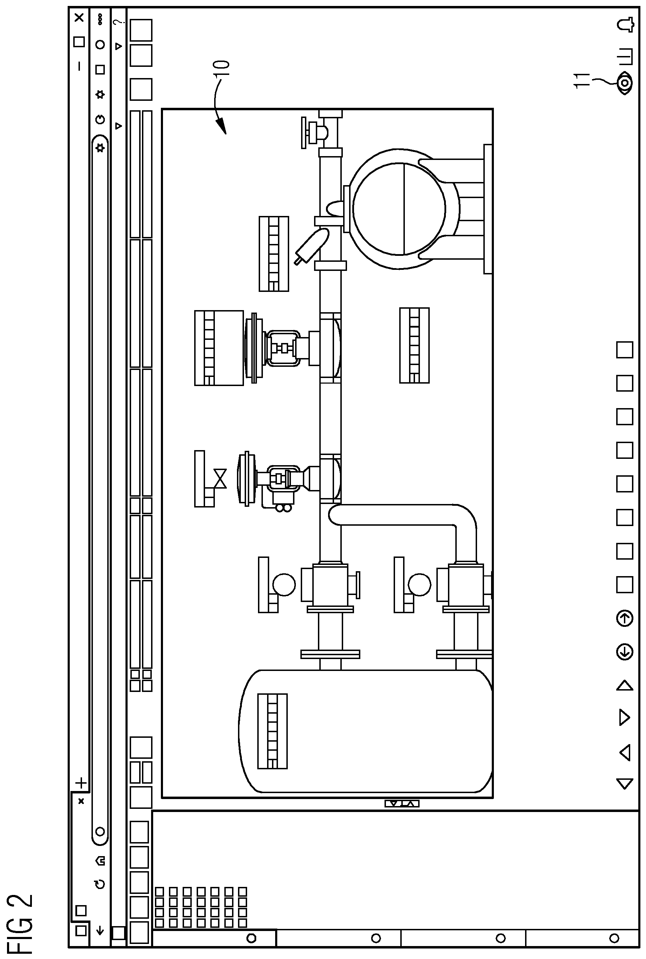

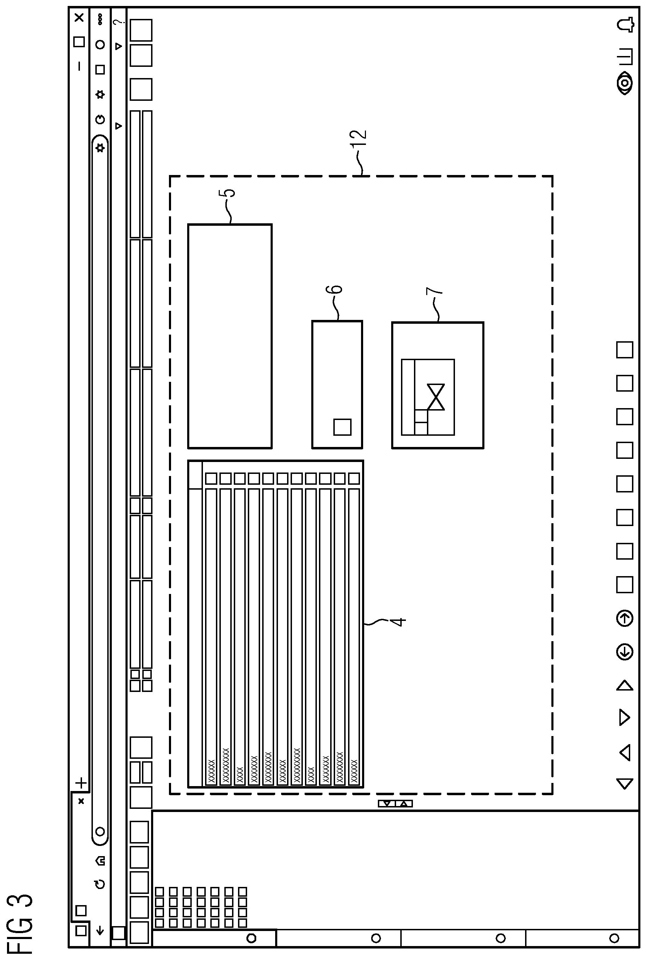

Die Anlagenbilder, welche dem Testbild zugrunde liegen, können in einer Engineering -bzw. Projektierungsphase der Automatisierung für die Prozessanlage festgelegt worden sein. Es ist aber auch möglich, dass der Operator direkt zur Laufzeit der Prozessanlage festlegt, welches Anlagenbild für das Testbild 2 berücksichtigt werden soll. In FIG 2 ist ein Anlagenbild 10 dargestellt, welches der Operator für ein Testbild berücksichtigen kann. Hierzu muss der Operator lediglich ein entsprechendes Anforderungssymbol 11 anwählen (durch Mausklick oder durch Antippen mit einem Finger). Das Anlagenbild 10 wird infolgedessen für das Testbild 12 (vgl. FIG 3) berücksichtigt.

Das Testbild 12 zeigt dem Operator dieselben Bereiche 4, 5, 6, 7, welche nun jedoch ausschließlich Inhalte aufweisen, die in dem Anlagenbild 10 enthalten sind. Durch diese "Ad hoc" Funktionalität kann der Operator bei dem jedem Anlagenbild prüfen, ob die in dem geöffneten Anlagenbild dargestellten Inhalten auch korrekt zu erkennen sind. Dies kann insbesondere dann relevant sein, wenn er die Prozessanlage mit einem mobilen Endgerät im Feld bei starker Sonneneinstrahlung bedienen und beobachten möchte.

In FIG 4 ist ein Leitsystem 13 für die Bedienung und Beobachtung der Prozessanlage schematisch dargestellt. Das Leitsystem 13 umfasst einen Operator Station Client 14 und einen mit dem Operator Station Client 14 verbundenen Operator Station Server 15. Der Operator Station Server 15 und der Operator Station Client 13 sind über einen Terminalbus 16 miteinander und mit einem Engineering Station Server 17 des Leitsystems 13 verbunden.

Ein Benutzer bzw. Operator kann zum Zwecke des Bedienens und Beobachtens über den Operator Station Client 14 mittels des Terminalbus 16 auf den Operator Station Server 15 zugreifen. Der Terminalbus 16 kann, ohne sich darauf zu beschränken, beispielsweise als Industrial Ethernet ausgebildet sein.

Der Operator Station Server 15 weist eine Geräteschnittstelle 18 auf, die mit einem Anlagenbus 19 verbunden ist. Über diese Geräteschnittstelle 18 kann der Operator Station Server 15 mit einem Automatisierungsgerät (nicht dargestellt) sowie mit optional vorhandenen weiteren Komponenten der verfahrenstechnischen Anlage wie Peripheriegeräten (nicht dargestellt) kommunizieren. Der Anlagenbus 19 kann, ohne sich darauf zu beschränken, beispielsweise als Industrial Ethernet ausgebildet sein.

Auf dem Operator Station Server 15 sind (unter anderem) ein Visualisierungsdienst 20, ein Prozessabbild 21 und ein Konfigurationsspeicher 22 implementiert. Der in dem Operator Station Server 15 integrierte Visualisierungsdienst 20 initiiert eine Übertragung von Visualisierungsinformationen an den Operator Station Client 14. Der Operator Station Client 14 ist dazu ausgebildet, eine Visualisierung, d.h. eine grafische Darbietung, insbesondere von Anlagenbildern, zum Bedienen und Beobachten der Prozessanlage darzustellen.

In dem Prozessabbild 21 des Operator Station Servers 15 ist eine Momentaufnahme der (Signal-) Zustände von mit dem Operator Station Server 15 verbundenen Geräten und/oder Applikationen (in der Figur nicht dargestellt) hinterlegt. Ein Alarmdienst 23 kann Alarmmeldungen aus dem Prozessabbild 21 auslesen und beispielsweise eine grafische Aggregation der Alarmmeldungen erzeugen, die der Operator Station Client 14 darstellen kann.

In einem Projektierungswerkzeug 24 werden u.a. Anlagenbilder 10 für eine Bedienung und Beobachtung der Prozessanlage erzeugt und mittels eines Ladedienstes 25 in den Konfigurationsspeicher 22 des Operator Station Servers 15 geladen. Ebenso wird das Testbild 2 durch den Engineering Station Server 17 erzeugt und in dem Konfigurationsspeicher 22 hinterlegt. Der Visualisierungsdienst 20 verwendet diese Informationen, um dem Operator die Anlagenbilder 10 und das Testbild 2 darzubieten.

Wenn der Operator das Testbild 12 direkt zur Laufzeit der Prozessanlage anstößt, greift ein Unterdienst 26 des Visualisierungsdienstes 15 auf die Daten zu den Anlagenbildern 10 aus dem Konfigurationsspeicher 22 zu und erzeugt das gewünschte Testbild 12.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Leitsystem (13) für eine Fertigungs- oder Prozessanlage, das wenigstens einen Operator Station Server (15) und wenigstens einen mit dem Operator Station Server (15) verbundenen Operator Station Client (14) umfasst, wobei der Operator Station Server (15) dazu ausgebildet ist, Visualisierungsinformationen an den Operator Station Client (14) zu übertragen, wobei die Visualisierungsinformationen eine Mehrzahl von wechselbaren Anlagenbildern (10) umfassen, und wobei der Operator Station Client (14) dazu ausgebildet ist, die Visualisierungsinformationen mit den wechselbaren Anlagenbildern (10) für einen Operator der Fertigungs- oder Prozessanlage darzubieten,
**dadurch gekennzeichnet, dass**
das Leitsystem (13) dazu ausgebildet ist, dem Operator der Fertigungs- oder Prozessanlage zur Laufzeit der Fertigungs- oder Prozessanlage ein von den Anlagenbildern (10) verschiedenes Testbild (3, 12) darzubieten, welches einen Farbbereich (4) mit den in wenigstens zwei der Anlagenbilder (10) der Visualisierungsinformationen verwendeten Farben umfasst,
und dass das Leitsystem (13) dazu ausgebildet ist, eine dem Testbild (3, 12) zugeordnete Alarmmeldung zu erzeugen, welche durch den Operator quittierbar ist, wobei das Leitsystem (13) dazu ausgebildet ist, dem Operator eine visuelle Darbietung der Anlagenbilder (10) zu verweigern, bis die dem Testbild (3, 12) zugeordnete Alarmmeldung quittiert worden ist.

2. Leitsystem (13) nach Anspruch 1, bei dem das Testbild (3, 12) einen Farbbereich (4) mit den in allen Anlagenbildern (10) der Visualisierungsinformationen verwendeten Farben umfasst.

3. Leitsystem (13) nach Anspruch 1 oder 2, bei dem das Testbild (3, 12) einen Textbereich (5) mit den in den Anlagenbildern (10) verwendeten Schriften und Schriftgrößen umfasst.

4. Leitsystem (13) nach einem der vorangegangenen Ansprüche, bei dem das Testbild (3, 12) einen Blinkbereich (6) mit den in den Anlagenbildern (10) verwendeten Blinkfrequenzen umfasst.

5. Leitsystem (13) nach einem der vorangegangenen Ansprüche, bei dem das Testbild (3, 12) einen Symbolbereich (7) mit nach bestimmten Kriterien ausgewählten, in den Anlagenbildern (10) enthaltenen Symbolbildern umfasst.

6. Leitsystem (13) nach Anspruch 5, bei dem die Symbolbilder gemäß ihrer Größe ausgewählt werden, derart, dass der Symbolbereich (7) eine zu bestimmende Anzahl der kleinsten Symbolbilder umfasst.

7. Leitsystem (13) nach einem der vorangegangenen Ansprüche, bei dem von dem Operator der Fertigungs- oder Prozessanlage zur Laufzeit der Fertigungs- oder Prozessanlage vorgebbar ist, welche der Anlagenbilder (10) für die Erzeugung des Testbildes (3, 12) berücksichtigt werden sollen.

8. Leitsystem (13) nach einem der vorangegangenen Ansprüche, das dazu ausgebildet ist, bei einer Anwahl eines Bereiches des Testbildes (3, 12) dem Operator das Anlagenbild (10) visuell darzubieten, welches bei der Erzeugung des Bereiches berücksichtigt worden ist.

9. Leitsystem (13) nach einem der vorangegangenen Ansprüche, bei dem die Alarmmeldung als durch den Operator kommentierbar ausgebildet ist.

10. Leitsystem (13) nach einem der vorangegangenen Ansprüche, bei dem die Erzeugung der Alarmmeldung von einem Aufenthaltsort und/oder einer Identität und/oder einer Rolle des Operators abhängig ist.

11. Verfahren zum Betreiben eines Leitsystems (13) für eine Fertigungs- oder Prozessanlage, das wenigstens einen Operator Station Server (15) und wenigstens einen Operator Station Client (14) umfasst, wobei der Operator Station Server (15) dazu ausgebildet ist, Visualisierungsinformationen an den Operator Station Client (14) zu übertragen, wobei die Visualisierungsinformationen eine Mehrzahl von wechselbaren Anlagenbildern (10) umfassen, und wobei der Operator Station Client (14) dazu ausgebildet ist, die Visualisierungsinformationen mit den wechselbaren Anlagenbildern (10) für einen Operator der Fertigungs- oder Prozessanlage darzubieten, wobei das Leitsystem (13) dem Operator der Fertigungs- oder Prozessanlage zur Laufzeit der Fertigungs- oder Prozessanlage ein Testbild (3, 12) darbietet, welches einen Farbbereich (4) mit den in wenigstens zwei der Anlagenbilder (10) der Visualisierungsinformationen verwendeten Farben umfasst, und wobei das Leitsystem (13) eine dem Testbild (3, 12) zugeordnete Alarmmeldung erzeugt, welche durch den Operator quittierbar ist, wobei das Leitsystem (13) dem Operator eine visuelle Darbietung der Anlagenbilder (10) verweigert, bis die dem Testbild (3, 12) zugeordnete Alarmmeldung quittiert worden ist.

12. Verfahren nach Anspruch 11, bei dem der Operator der Fertigungs- oder Prozessanlage vorgibt, welche der Anlagenbilder (10) für die Erzeugung des Testbildes (3, 12) berücksichtigt werden sollen.

## Claims

1. Control system (13) for a manufacturing or process installation, which comprises at least one operator station server (15) and at least one operator station client (14) connected to the operator station server (15), wherein the operator station server (15) is embodied to transfer visualisation information to the operator station client (14), wherein the visualisation information comprises a plurality of exchangeable installation images (10), and wherein the operator station client (14) is embodied to present the visualisation information with the exchangeable installation images (10) to an operator of the manufacturing or process installation,
**characterised in that**
the control system (13) is embodied to present the operator of the manufacturing or process installation, at the runtime of the manufacturing or process installation, with a test image (3, 12) which differs from the installation images (10) and comprises a colour region (4) having the colours used in at least two of the installation images (10) of the visualisation information
and that the control system (13) is embodied to generate an alarm message which is associated with the test image (3, 12), which can be acknowledged by the operator, wherein the control system (13) is embodied to withhold a visual presentation of the installation images (10) from the operator until the alarm message associated with the test image (3, 12) has been acknowledged.

2. Control system (13) according to claim 1, in which the test image (3, 12) comprises a colour region (4) having the colours used in all of the installation images (10) of the visualisation information.

3. Control system (13) according to claim 1 or 2, in which the test image (3, 12) comprises a text region (5) having the fonts and font sizes used in the installation images (10).

4. Control system (13) according to one of the preceding claims, in which the test image (3, 12) comprises a flashing region (6) having the flashing frequencies used in the installation images (10).

5. Control system (13) according to one of the preceding claims, in which the test image (3, 12) comprises a symbol region (7) having symbol images, selected according to certain criteria, contained in the installation images (10).

6. Control system (13) according to claim 5, in which the symbol images are selected according to their size such that the symbol region (7) comprises a number, to be determined, of the smallest symbol images.

7. Control system (13) according to one of the preceding claims, in which the operator of the manufacturing or process installation can specify, at the runtime of the manufacturing or process installation, which of the installation images (10) are to be taken into consideration for generating the test image (3, 12).

8. Control system (13) according to one of the preceding claims, which is embodied, upon selection of a region of the test image (3, 12), to visually present the operator with the installation image (10) which was taken into consideration when generating the region.

9. Control system (13) according to one of the preceding claims, in which the alarm message is embodied such that the operator is able to make comments on it.

10. Control system (13) according to one of the preceding claims, in which the generation of the alarm message is dependent on a location and/or an identity and/or a role of the operator.

11. Method for operating a control system (13) for a manufacturing or process installation, which comprises at least one operator station server (15) and at least one operator station client (14), wherein the operator station server (15) is embodied to transfer visualisation information to the operator station client (14), wherein the visualisation information comprises a plurality of exchangeable installation images (10), and wherein the operator station client (14) is embodied to present the visualisation information with the exchangeable installation images (10) to an operator of the manufacturing or process installation, wherein the control system (13) presents the operator of the manufacturing or process installation, at the runtime of the manufacturing or process installation, with a test image (3, 12) comprising a colour region (4) having the colours used in at least two of the installation images (10) of the visualisation information, and wherein the control system (13) generates an alarm message which is associated with the test image (3, 12), which can be acknowledged by the operator, wherein the control system (13) withholds a visual presentation of the installation images (10) from the operator until the alarm message associated with the test image (3, 12) has been acknowledged.

12. Method according to claim 11, in which the operator of the manufacturing or process installation specifies which of the installation images (10) are to be taken into consideration for generating the test image (3, 12).

## Revendications

1. Système (13) de conduite d'une installation de fabrication ou de processus, qui comprend au moins un operator station server (15) et au moins un operator station client (14) relié à l'operator station server (15), dans lequel l'operator station server (15) est constitué pour transmettre des informations de visualisation à l'operator station client (14), dans lequel les informations de visualisation comprennent une pluralité d'images (10) d'installations variables, et dans lequel l'operator station client (14) est constitué pour représenter les informations de visualisation avec les images (10) d'installations variables à un opérateur de l'installation de fabrication ou de processus,
**caractérisé en ce que**
le système (13) de conduite est constitué pour représenter à l'opérateur de l'installation de fabrication ou de processus, pendant le temps de fonctionnement de l'installation de fabrication ou de processus, une image (3, 12) de test différente des images (10) d'installations, qui comprend une partie (4) en couleur ayant les couleurs utilisées dans au moins deux des images (10) d'installations des informations de visualisation,
et **en ce que** le système (13) de conduite est constitué pour produire, associé à l'image (3, 12) de test, un message d'alerte, dont l'opérateur peut accuser réception, dans lequel le système (13) de conduite est constitué pour refuser à l'opérateur une représentation visuelle des images (10) d'installations jusqu'à ce qu'il ait été accusé réception du message d'alerte associé à l'image (3, 12) de test.

2. Système (13) de conduite suivant la revendication 1, dans lequel l'image (3, 12) de test comprend une partie (4) en couleur ayant les couleurs utilisées dans toutes les images (10) d'installations des informations de visualisation.

3. Système (13) de conduite suivant la revendication 1 ou 2, dans lequel l'image (3, 12) de test comprend une partie (5) de texte ayant les caractères et les tailles de police utilisés dans les images (10) d'installations.

4. Système (13) de conduite suivant l'une des revendications précédentes, dans lequel l'image (3, 12) de test comprend une partie (6) de clignotement ayant les fréquences de clignotement utilisées dans les images (10) d'installations.

5. Système (13) de conduite suivant l'une des revendications précédentes, dans lequel l'image (3, 12) de test comprend une partie (7) de symbole ayant des images de symbole sélectionnées suivant des critères déterminés et contenues dans les images (10) d'installations.

6. Système (13) de conduite suivant la revendication 5, dans lequel les images de symbole sont sélectionnées suivant leur dimension, de manière à ce que la partie (7) de symbole comprenne un nombre à déterminer des images de symbole les plus petites.

7. Système (13) de conduite suivant l'une des revendications précédentes, dans lequel il peut être prescrit par l'opérateur de l'installation de fabrication ou de processus pendant le temps de fonctionnement de l'installation de fabrication de processus, celles des images (10) d'installations, dont on doit tenir compte pour la production de l'image (3, 12) de test.

8. Système (13) de conduite suivant l'une des revendications précédentes, qui est constitué pour, lors d'un choix d'une partie de l'image (3, 12) de test, représenter visuellement à l'opérateur l'image (10) d'installations, dont il a été tenu compte lors de la production de la partie.

9. Système (13) de conduite suivant l'une des revendications précédentes, dans lequel le message d'alerte est constitué de manière à pouvoir être commenté par l'opérateur.

10. Système (13) de conduite suivant l'une des revendications précédentes, dans lequel la production du message d'alerte dépend d'un lieu de séjour et/ou d'une identité et/ou d'un rôle de l'opérateur.

11. Procédé pour faire fonctionner un système (13) de conduite d'une installation de fabrication ou de processus, qui comprend au moins un operator station server (15) et au moins un operator station client (14), dans lequel l'operator station server (15) est constitué pour transmettre des informations de visualisation à l'operator station client (14), dans lequel les informations de visualisation comprennent une pluralité d'images (10) d'installations variables, et dans lequel l'operator station client (14) est constitué pour représenter les informations de visualisation avec les images (10) d'installations variables à un opérateur de l'installation de fabrication ou de processus, dans lequel le système (13) de conduite représente à l'opérateur de l'installation de fabrication de processus, pendant le temps de fonctionnement de l'installation de fabrication de processus, une image (3, 12) de test, qui comprend une partie (4) en couleur ayant les couleurs utilisées dans au moins deux des images (10) d'installations des informations de visualisation, et dans lequel le système (13) de conduite produit, associé à l'image (3, 12) de test un message d'alerte, dont l'opérateur peut accuser réception, dans lequel le système (13) de conduite est constitué pour refuser à l'opérateur une représentation visuelle des images (10) d'installations jusqu'à ce qu'il ait été accusé réception du message d'alerte associé à l'image (3, 12) de test.

12. Procédé suivant la revendication 11, dans lequel l'opérateur de l'installation de fabrication ou de processus prescrit celles des images (10) d'installations, dont il faut tenir compte pour la production de l'image (3, 12) de test.
